# EUROPÄISCHE PATENTANMELDUNG

(11) **EP 2 256 801 A2**
(43) Veröffentlichungstag der Anmeldung: **01.12.2010**
(21) Anmeldenummer: 10003118.6
(22) Anmeldetag: 24.03.2010
(51) Int. Cl.: H01L 23/48, H05K 3/32

(54) **Kontakteinrichtung für ein Leistungshalbleitermodul mit einer Zentriervertiefung**

(30) Priorität: 26.05.2009 DE 102009022659
(71) Anmelder: Semikron Elektronik GmbH & Co. KG Patentabteilung, 90431 Nürnberg (DE)
(72) Erfinder: Mauer, Peter, 90766 Fürth (DE)

(57) **Zusammenfassung**

Es wird eine Kontakteinrichtung für ein Leistungshalbleitermodul beschrieben, die ein federndes Kontaktelement mit einem Kontaktierungs-Endabschnitt (18) aufweist, der zur Kontaktierung mit einem Anschlusselement (14) eines ebenen Schaltungsträgers (12) des Leistungshalbleitermoduls vorgesehen ist. Der Kontaktierungs-Endabschnitt (18) ist geradlinig stiftförmig ausgebildet und das Anschlusselement (14) weist ein Chipbauteil (10) auf, das mit einer Zentriervertiefung (16) für den Kontaktierungs-Endabschnitt (18) des federnden Kontaktelementes ausgebildet ist.

## Beschreibung

Die Erfindung betrifft eine Kontakteinrichtung für ein Leistungshalbleitermodul, die ein federndes Kontaktelement mit einem Kontaktierungs-Endabschnitt aufweist, der zur Kontaktierung mit einem Anschlusselement des Leistungshalbleitermoduls vorgesehen ist.

Aus der DE 10 2005 055 713 A1 ist ein Leistungshalbleitermodul bekannt, das federnde Kontaktelemente in Gestalt von Tonnenfedern aufweisen kann. Jeder Tonnenfeder ist mit einem geradlinig stiftförmigen Kontaktierungs-Endabschnitt ausgebildet, der zur Kontaktierung mit einem Anschlusselement dieses bekannten Leistungshalbleitermoduls vorgesehen ist. Das entsprechende Anschlusselement kann eine Kontaktfläche eines Leistungshalbleiterbauelementes oder einer Leiterbahn eines Substrates des Leistungshalbleitermoduls sein.

Eine Kontakteinrichtung für Leistungshalbleitermodule und Scheibenzellen ist aus der DE 10 2004 050 588 A1 bekannt. Diese bekannte Kontakteinrichtung weist federnde Kontaktelemente auf, die als Tonnenfedern ausgebildet sein können, deren Kontaktierungs-Endabschnitte geradlinig stiftartig mit unterschiedlich gestalteten Kontaktenden ausgebildet sein können. Dabei kann es sich beispielsweise um ein bogenförmiges Kontaktende handeln.

Unabhängig von der jeweiligen speziellen Ausbildung des Kontaktierungs-Endabschnittes des federnden Kontaktelementes ist bei den bekannten Kontakteinrichtungen temperaturbedingt und daraus resultierend wärmedehnungsbedingt eine kleine relative Bewegung zwischen dem jeweiligen Kontaktierungs-Endabschnitt des federnden Kontaktelementes und dem zugehörigen Anschlusselement des Leistungshalbleitermoduls nicht vermeidbar. Aus dieser Relativbewegung kann insbesondere nach einer langen Einsatz- bzw. Lebensdauer des Leistungshalbleitermoduls ein unerwünschter Materialabtrag am Kontaktierungs-Endabschnitt des federnden Kontaktelementes und/oder am Anschlusselement des Leistungshalbleitermoduls resultieren, der im Extremfall sogar zu einem Ausfall des Leistungshalbleitermoduls führen kann.

Bei den bekannten Kontakteinrichtungen für Leistungshalbleitermodule wird das jeweilige Anschlusselement veredelt, um eine gewünschte Einsatz- bzw. Lebensdauer des Leistungshalbleitermoduls zu gewährleisten. Diese Veredelung wird bekanntermaßen auf das gesamte Substrat des Leistungshalbleitermoduls angewandt.

Der Erfindung liegt die Aufgabe zugrunde, eine Kontakteinrichtung der eingangs genannten Art zu schaffen, die einfach ausgebildet ist und die über die gesamte Lebensdauer des Leistungshalbleitermoduls gleich bleibende Kontakteigenschaften gewährleistet.

Diese Aufgabe wird erfindungsgemäß durch die Merkmale des Anspruches 1, d.h. dadurch gelöst, dass das Anschlusselement ein Chipbauteil mit einer Zentriervertiefung für den Kontaktierungs-Endabschnitt des federnden Kontaktelementes aufweist.

Durch das Chipbauteil mit seiner Zentriervertiefung ergibt sich in vorteilhafter Weise eine Selbstzentrierung des Kontaktierungs-Endabschnittes des zugehörigen federnden Kontaktelementes und somit über die gesamte Lebensdauer des Leistungshalbleitermoduls ein gleich bleibender Kontakt zwischen dem federnden Kontaktelement und dem Chipbauteil des Anschlusselementes.

Zweckmäßigerweise ist das Chipbauteil als automatisch SMD-bestückbares Bauteil (Surface Mounted Device) ausgebildet. Das als automatisch SMD-bestückbares Bauteil ausgebildete erfindungsgemäße Chipbauteil kann auf dem zugehörigen Anschlusselement des Leistungshalbleitermoduls mit handelsüblichen Bestückungsautomaten bestückt und stoffschlüssig verbunden werden. Dabei ist die Form d.h. die Gestalt und seine so genannte Veredelung auf das Material des federnden Kontaktelementes des Leistungshalbleitermoduls abgestimmt.

Erfindungsgemäß kann das Chipbauteil eine von einer Metallisierung gebildete Veredelung aufweisen, die auf das Material des federnden Kontaktelementes abgestimmt ist.

Diese Metallisierung kann zumindest in der Zentriervertiefung vorgesehen sein, wenn das Chipbauteil selbst aus einem elektrisch leitenden Material besteht. Desgleichen ist es möglich, dass das Chipbauteil aus einem isolierenden Material besteht und oberflächlich metallisiert ist, wobei die spezielle Veredlungs-Metallisierung zumindest in der Zentriervertiefung vorgesehen ist.

Die Zentriervertiefung kann im Chipbauteil kugelabschnittförmig, kegelig, kegelstumpfförmig oder beliebig anders gestaltet sein. Von Wichtigkeit ist nur, dass die Zentriervertiefung des am Anschlusselement des Leistungshalbleitermoduls fixierten Chipbauteils eine Selbstzentrierung des Kontaktierungs-Endabschnittes des zugehörigen federnden Kontaktelementes bewirkt.

Wie bereits weiter oben erwähnt worden ist, sind die Form d.h. Gestalt und die Veredelung des Chipbauteils auf das Material des federnden Kontaktelementes bzw. seines Kontaktierungs-Endabschnittes abgestimmt. Vorteilhaft ist es hierbei, dass die Zentrieroberfläche des Chipbauteils unabhängig vom jeweiligen Substrat- bzw. Leiterplattenhersteller und/oder von der jeweiligen Substrat- bzw. Leiterplatten-Technologie immer gleich ist. Die Bestückung und die Lötkontaktierung des jeweiligen Chipbauteils kann in vorteilhafter Weise mit Hilfe eines Standardprozesses des jeweiligen Bestückers erfolgen. Dabei kann die Positioniergenauigkeit des Chipbauteils in Bezug zum Substrat bzw. im Bezug zur zugehörigen Leiterplatte beispielsweise durch Kerben im auf der Leiterplatte bzw. auf dem Substrat vorgesehenen Lötstopplack sehr genau eingehalten werden.

Weitere Einzelheiten, Merkmale und Vorteile der erfindungsgemäßen Kontakteinrichtung ergeben sich aus der nachfolgenden Beschreibung anhand der anschließenden Zeichnungen.

Es zeigen:
- Figur 1: eine perspektivische Ansicht eines Chipbauteils auf einem Substrat bzw. auf einer Leiterplatte, die als PCB (Printed Circuit Board) ausgebildet ist,
- Figur 2: schematisch eine Schnittdarstellung durch eine Ausführungsform des Chipbauteils, und
- Figur 3: eine der Figur 2 ähnliche prinzipielle Schnittdarstellung einer anderen Ausführungsform des Chipbauteils.

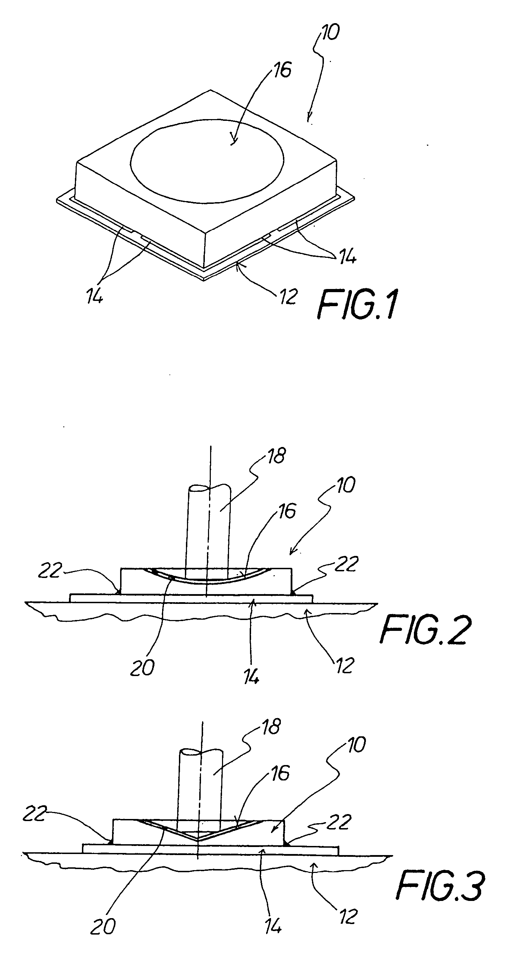

Figur 1 zeigt perspektivisch ein Chipbauteil 10 mit einer viereckigen Grundfläche. Das aus einem elektrisch leitfähigen Material bestehende Chipbauteil 10 ist auf einem ebenen Schaltungsträger 12 angeordnet, um eine Kontaktierung mit einem Anschlusselement 14 zu bewirken.

Bei dem ebenen Schaltungsträger 12 kann es sich um ein Substrat (DCB) bpsw. aus Aluminiumoxid oder um eine gedruckte Schaltungsplatte (PCB) handeln.

Das Chipbauteil 10 ist mit einer Zentriervertiefung 16 für einen Kontaktierungs-Endabschnitt 18 eines federnden Kontaktelementes ausgebildet. Ein solcher Kontaktierungs-Endabschnitt 18 ist jeweils in den Figuren 2 und 3 mit dünnen Linien verdeutlicht. Der jeweilige Kontaktierungs-Endabschnitt 18 kann in vorteilhafter Weise einfach geradlinig stiftförmig ausgebildet sein, so dass er in Projektion auf das zugehörige Anschlusselement 14 des ebenen Schaltungsträgers 12 nur eine kleine Projektionsfläche d.h. Grundfläche benötigt, und das zugehörige Chipbauteil 10 kann mit einer entsprechend kleinen Grundfläche dimensioniert sein.

In Figur 2 ist eine Zentriervertiefung 16 verdeutlicht, die kugelabschnittsförmig ausgebildet ist. Demgegenüber verdeutlicht die Figur 3 eine Zentriervertiefung 16, die kegelig ausgebildet ist.

Das Chipbauteil 10 weist eine Metallisierung 20 auf, die auf das Material des federnden Kontaktelementes bzw. seines Kontaktierungs-Endabschnittes 18 abgestimmt ist. Diese Metallisierung 20 ist zumindest in der Zentriervertiefung 16 vorgesehen und bildet eine Kontaktierungs-Veredelung.

Das Chipbauteil 10 ist auf dem zugehörigen Anschlusselement 14 fest gelötet. Diese Lötverbindung ist in den Figuren 2 und 3 mit der Bezugsziffer 22 bezeichnet.

### Bezugsziffernliste:

- 10: Chipbauteil (auf 12)
- 12: ebener Schaltungsträger
- 14: Anschlusselement (an 12)
- 16: Zentriervertiefung (von 10 für 18)
- 18: Kontaktierungs-Endabschnitt
- 20: Metallisierung (von 10 bzw. in 16)
- 22: Lötverbindung (von 10 an 14)

## Patentansprüche

1. Kontakteinrichtung für ein Leistungshalbleitermodul, die ein federndes Kontaktelement mit einem Kontaktierungs-Endabschnitt (18) aufweist, der zur Kontaktierung mit einem Anschlusselement (14) eines ebenen Schaltungsträgers (12) des Leistungshalbleitermoduls vorgesehen ist,
**dadurch gekennzeichnet,**
**dass** das Anschlusselement (14) ein Chipbauteil (10) mit einer Zentriervertiefung (16) für den Kontaktierungs-Endabschnitt (18) des federnden Kontaktelementes aufweist.

2. Kontakteinrichtung nach Anspruch 1,
**dadurch gekennzeichnet,**
**dass** das Chipbauteil (10) als automatisch SMD-bestückbares Bauteil ausgebildet ist.

3. Kontakteinrichtung nach Anspruch 1,
**dadurch gekennzeichnet,**
**dass** das Chipbauteil (10) mit dem Anschlusselement (14) des ebenen Schaltungsträgers (12) stoffschlüssig verbunden ist.

4. Kontakteinrichtung nach Anspruch 1,
**dadurch gekennzeichnet,**
**dass** die Zentriervertiefung (16) im Chipbauteil (10) kugelabschnittförmig oder kegelförmig ausgebildet ist.

5. Kontakteinrichtung nach Anspruch 1,
**dadurch gekennzeichnet,**
**dass** das Chipbauteil (10) vollständig aus Metall besteht.

6. Kontakteinrichtung nach Anspruch 5,
**dadurch gekennzeichnet,**
**dass** das Metall des Chipbauteils (10) auf das Material des Kontaktierungs-Endabschnittes (18) des federnden Kontaktelementes abgestimmt ist.

7. Kontakteinrichtung nach Anspruch 1,
**dadurch gekennzeichnet,**
**dass** das Chipbauteil (10) eine Metallisierung (20) aufweist, die auf das Material des Kontaktierungs-Endabschnittes (18) des federnden Kontaktelementes abgestimmt ist.

8. Kontakteinrichtung nach Anspruch 7,
**dadurch gekennzeichnet,**
**dass** die Metallisierung (20) zumindest in der Zentriervertiefung (16) des Chipbauteils (10) vorgesehen ist.
